Europäisches Patentamt

(19) European Patent Office

Office européen des brevets

(11) EP 0 911 982 A1

(12) EUROPEAN PATENT APPLICATION

(43) Date of publication:
28.04.1999 Bulletin 1999/17

(51) Int. Cl.$^6$: H03M 13/00, G11B 20/18

(21) Application number: 97402487.9

(22) Date of filing: 21.10.1997

(84) Designated Contracting States:
AT BE CH DE DK ES FI FR GB GR IE IT LI LU MC
NL PT SE
Designated Extension States:
AL LT LV RO SI

(71) Applicant:
DEUTSCHE THOMSON-BRANDT GMBH
78048 Villingen-Schwenningen (DE)

(72) Inventor: Rominger, Friedrich
78086 Brigachtal (DE)

(74) Representative:
Hartnack, Wolfgang, Dipl.-Ing. et al
Deutsche Thomson-Brandt GmbH
Licensing & Intellectual Property,
Karl-Wiechert-Alee 74
30625 Hannover (DE)

(54) Reed Solomon error correction with shared memory approach

(57) A Reed Solomon error correction device (1) corrects data which is received in Reed Solomon blocks. The error correction device performs an inner correction (4,5) of Reed Solomon code words of the Reed Solomon block, evaluates (6) and stores (7) outer syndromes for data symbols of the inner corrected Reed Solomon code words and outputs (8) the inner corrected Reed Solomon code words to an external storage device (9). When all the code words of the Reed Solomon block have been inner corrected and stored into the external storage device, the error correction device performs an outer correction of data symbols in the external storage device.

FIG. 2

**Description**

The invention relates to a Reed Solomon (RS) error correction device which corrects data from a RS block.

The invention also relates to a data reading and/or writing device which comprises a RS error correction device.

The invention also relates to a method for correcting data organized inside of a RS block by using a RS error correction device.

RS coding of data is widespread in storage and transmission of data because it allows to detect and correct a determined number of errors in the data with a relatively high efficiency.

An example for RS coding is a RS block which comprises a plurality of RS code words. RS blocks may e.g. be found on optical Digital Versatile Discs (DVD).

Each RS code word of the RS block comprises data and/or parity symbols which contain data and parity information respectively. The parity symbols are chosen such that together with the data symbols the RS code word forms a RS code. Each symbol inside the code word has a coordinate.

Some RS code words of the RS block have parity symbols at coordinates where other code words have data symbols. The parity symbols of these RS code words are chosen in a way such that on one hand each of these RS code words forms a RS code and on the other hand all data and parity symbols with the same coordinate inside the RS block, i.e. from all the RS code words inside the RS block together form a RS code for this same coordinate.

Details on RS block used in DVDs may be found in the reference *DVD specifications for Read-Only Discs*, chapter 3.2.

A correction of data in the RS block is typically performed in a RS error correction device. The RS block is at first inputted in the RS error correction device and locally stored in a memory of the Random Access Memory (RAM) type inside the RS error correction device. For each RS code word of the RS block an inner syndrome is evaluated. The evaluation of the syndrome is well know by a man skilled in the art and will not be explained in detail here. The subject is for example discussed in a book entitled *Reed Solomon Codes and Their Applications*, edited by Stephen B. Wicker and Vijay K. Bhargava, IEEE press, 1994. The inner syndrome of a RS code word is used to determine coordinates of erroneous symbols in the RS code word and/or to correct erroneous symbols. The RS code word is locally corrected in the RAM by replacing erroneous symbols with correct symbols. Once all RS code words have been corrected the evaluation of an outer syndrome for symbols out of all the inner corrected RS code words and having the same coordinate is performed. The outer syndrome of the latter symbols allows to determine erroneous symbols and their correct value. The erroneous symbols are corrected in the RAM by overwriting them with their correct value. As a result of the foregoing the RAM contains a RS block which is inner and outer corrected. The corrected content of the RAM may then be outputted for further processing of the now corrected data contained in the RS block.

The described RS error correction device thus uses a RAM which is accessed to stored the RS block into it, to read the RS code words, to perform the inner correction of the RS code words, to read symbols having the same coordinate, to perform the outer correction on these symbols and finally to read the corrected RS block in order to output it. This requires a substantial bandwidth for data exchange between a processor of the RS error correction device and the RAM.

An improvement of the described error correction device may be achieved by an RS error correction device which requires less bandwidth. This may be done by evaluating the inner syndrome of a RS code word directly after it is inputted from the RS block. Erroneous symbols of the RS code word are determined and their correct values are calculated to obtain a corrected RS code word. Also for each coordinate and based on the symbols of the corrected RS code word an outer syndrome is evaluated and stored in a syndrome storage means. This is commonly referred to as 《evaluation of outer syndromes on the fly》. Subsequently the corrected RS code word is stored into the RAM type memory. This is repeated for every RS code word of the RS block until the complete RS block has been inputted. The RAM then contains inner corrected RS code words and the syndrome storage means contain an outer syndrome for each code word comprising the symbols of RS block which have the same coordinate. The outer correction which involves determining erroneous latter symbols, their correct values and replacing these erroneous latter symbols with their correct values in the RAM may then be performed.

The improved RS error correction device thus accesses the RAM to store inner corrected RS code words, to perform the outer correction of symbols and finally to read the inner and outer corrected RS block to output it. This mean that the improved device needs less accesses to the RAM to correct a single RS block than the first described example of the RS error correction device. This allows to use a cheaper RAM configuration in the improved device.

As suggested above by mentioning DVDs as an example for media in which data is stored in RS blocks, there is a need for RS error correction devices in DVD players and/or recorders. But other areas of application may be considered as for example communication links to and/or between satellites, magnetic tape storage devices etc... The growing number of applications is accompanied by a rising complexity and price of hardware components used.

A problem encountered in the known RS error correction devices is to further reduce hardware requirements to lower production costs at a minimum.

A solution to the mentioned problem is according to the invention found in a RS error correction device for correcting data providing from a RS block having a plurality of RS code words, each of said RS code words containing data and/or parity symbols such to enable an inner and an outer RS-coding of the data. The RS error correction device comprises input means to receive the RS code words from the RS block, first syndrome evaluating means which evaluate inner syndromes for the RS code words, inner correcting means for correcting the RS code words using the inner syndromes to obtain inner corrected RS code words, second syndrome evaluating means which evaluate outer syndromes for at least the data symbols of at least one of the inner corrected RS code words and which comprise syndrome storage means for storing the outer syndromes. It further comprises output means for outputting the inner corrected RS code words directly or indirectly to a storage device which is not comprised in the RS error correction device, and outer correcting means which enable an outer correction of the symbols in the inner corrected RS code words in the storage device using the outer syndromes stored in the syndrome storage means.

The RS error correction device according to the invention eliminates the need for an internal RAM type memory to store an inner corrected RS block inside of the RS error correction device. It takes advantage of the fact that storage capacity cheaper than the internal RAM is mostly available in devices peripheral to the RS error correction device.

A first preferred embodiment of the RS error correction device according to the invention comprises erasure polynomial means which allows to determine a coordinate of erroneous data and/or parity symbols in the RS code words.

The first preferred embodiment increases a number of symbols which may be corrected inside a RS code word.

In a second preferred embodiment of the RS error correction device according to the invention the input means comprise a buffer to store the RS code words.

In a third preferred embodiment of the RS error correction device according to the invention the data and/or parity symbols are 8 bits long.

The third preferred embodiment of the RS error correction device is adapted to the widespread 8 bit format in which data may be coded.

In a fourth preferred embodiment of the RS error correction device according to the invention the external storage device is also connected to an external device which uses said external storage device to at least store information.

The fourth preferred embodiment of the RS error correction device shares the external storage device with the external device. The external device may for example be an interface which allows to transmit corrected RS blocks.

A further solution to the mentioned problem is according to the invention found in a data reading and/or writing device which reads and/or writes data from and/or to a data medium, the data being organized on the data medium in at least one Reed-Solomon (RS) block having a plurality of RS code words, each of said RS code words containing data and/or parity symbols such to enable an inner and an outer RS coding of the data. It comprises interface means which have a storage device, reading means to receive the RS code words from the RS block, first syndrome evaluating means which evaluate inner syndromes for the RS code words, inner correcting means for correcting the RS code words using the inner syndromes to obtain inner corrected RS code words, second syndrome evaluating means which evaluate outer syndromes for at least the data symbols of at least one of the inner corrected RS code words and which comprise syndrome storage means for storing the outer syndromes. The interface means are directly or indirectly connected to the inner correcting means such that the inner corrected RS code words may be stored in said storage device, and indirectly connected through outer correcting means to said syndrome storage means, the outer correcting means enabling an outer correction of the symbols in the inner corrected RS code words in the storage device using the outer syndromes stored in said syndrome storage means.

RS decoding of the RS block is done in the data reading and/or writing device while using parts of the data reading and/or writing device like the storage device which are present anyway. Thus use of hardware is reduced.

In a first preferred embodiment of the data reading and/or writing device according to the invention the interface means comply with an ATAPI interface.

In a second preferred embodiment of the data reading and/or writing device according to the invention the interface means comply with an IEEE-1394 standard interface.

In a third preferred embodiment of the data reading and / or writing device according to the invention the interface means comply with a SCSI standard interface.

The ATAPI, IEEE-1394 and SCSI standard interface are industry standards for interfaces used to connect peripherals like hard disks, tape drives, CD-ROM, DVD-ROM/RAM to personal computers.

In a fourth preferred embodiment of the data reading and/or writing device according to the invention the storage device is used as a cache memory.

The interfaces are often used to cache data coming from devices they're connected to.

Still a further solution to the mentioned problem is found in a method for correcting data organized inside of a RS block in RS code words containing data and/or parity symbols such to enable an inner and an outer RS coding of the data, by using a Reed-Solomon error correction device comprising the steps of inputting a RS code word, determining an inner syndrome for the RS code word, correcting the RS code word using the inner syndrome and obtaining an inner corrected RS code word, determining outer syndromes for at least the data symbols of at least one inner corrected RS code word and storing the outer syndromes in a syndrome storage device. The method further comprises the steps of outputting the inner corrected RS code word to a storage device which is external to the RS error correction device, performing an outer correction of the data symbols of the inner corrected RS code words in the storage device using the stored outer syndromes.

The following detailed description of examples is intended to show how the invention may be carried out. The description refers to FIGs 1 to 4 wherein

FIG. 1 contains a representation of a RS block,
FIG. 2 contains a schematic representation of a RS error correction device,
FIG. 3 shows a RS block used in a DVD,
FIG. 4 contains a schematic representation of a data reading and/or writing device.

In the drawings and throughout the description same references will be used to designated same parts.

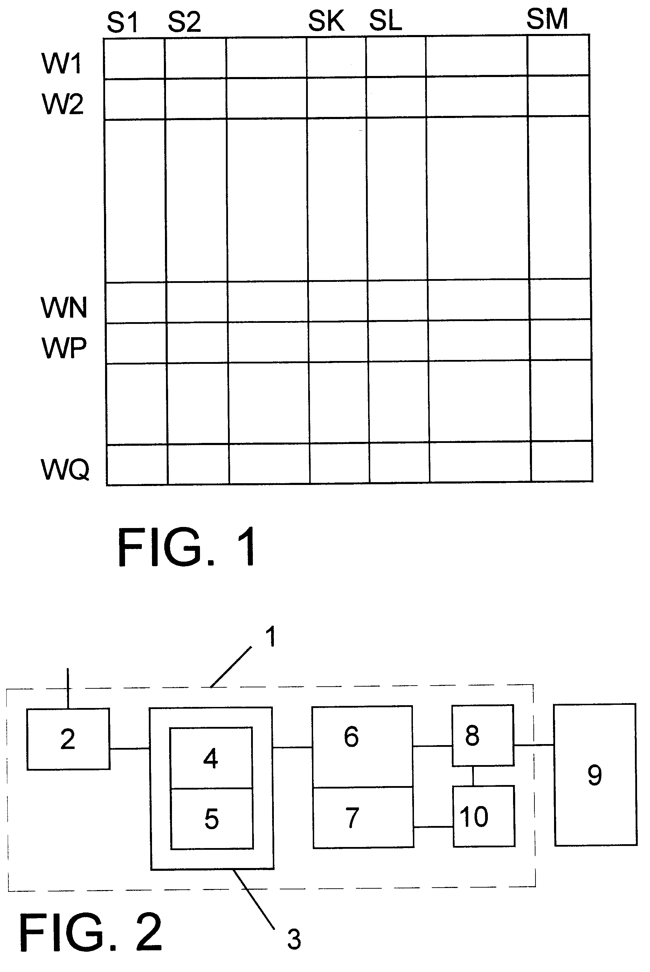

FIG. 1 contains a representation of data which is RS coded in a RS block. The RS block comprises a number Q of RS code words which are represented in lines and referenced from W1 to WQ. Each RS code word comprises a number M of symbols having each a coordinate ranging from S1 to SM. This way symbols comprised in the RS code word W1 may be referenced using M pairs (W1,S1), (W1,S2), ...., (W1,SM).
The symbols may either be data symbols or parity symbols. The actual data is stored in the data symbols. For example in the RS code word W1 the symbols (W1,S1), ..., (W1,SK) (K<M) may be data symbols. Parity symbols (W1,SL), ..., (W1,SM) (L=K+1) are chosen in a way such that W1 becomes a RS code.
The RS block comprises a number N of RS code words W1 to WN (N<Q) in which symbols having a coordinate in the range of S1 to SK are data symbols and symbols having a coordinate in the range of SL to SM are parity symbols.
The RS block further comprises RS code words WP to WQ (P=N+1) in which the symbols are parity symbols. The parity symbols (WP,S1), ..., (WQ,S1) i.e. the parity symbols in the RS code words WP to WQ which have the coordinate S1 are chosen in a way such that all symbols having the coordinate S1 out of all the RS code words W1 to WQ together make up a RS coded word. Other parity symbols in the RS code words WP to WQ, and having coordinates in the range of S2 to SK may be chosen in a similar way. The remaining parity symbols in the RS code words WP to WQ which have coordinates in the range of SL to SM may for example be chosen such that the RS code words WP to WQ each become RS coded.
FIG. 2 contains a schematic representation of a RS error correction device 1 which is comprised in a dotted box. Input means 2 receive RS code words W1, ..., WQ out of a RS block (not shown). An inner detection of errors and correction of errors in a RS code word received by the input means 2, e.g. W1 is performed in box 3. The box 3 comprises first syndrome evaluating means 4 which evaluate an inner syndrome (not shown) for the RS code word W1 and inner correcting means 5 which use at least the inner syndrome to correct the RS code word W1 and obtain an inner corrected RS code word W1 (not shown). Second syndrome evaluating means 6 evaluate outer syndromes (not shown) for at least each data symbol (W1,S1), ..., (W1,SK) and store the outer syndromes in syndrome storage means 7. The evaluation of the outer syndromes is said to be done on the fly. The corrected RS code word W1 is outputted with output means 8 to a storage device 9. The storage device 9 is external to the RS error correction device 1. Evaluation of inner syndromes, correction of RS code words and evaluation of outer syndromes is performed until all the code words W1, ..., WQ have been corrected and outputted to the storage device 9. At this point the syndrome means 7 contain outer syndromes which are used by outer correction means 10 to correct at least data symbols stored in the storage device 9. In FIG. 1 the outer correction means 10 access the storage device through the output means 8 but it is optionally possible to have a direct connection between the outer correcting means 10 and the storage device 9 (direct connection not shown).
The correction of data symbols stored in the storage device 9 is done coordinate wise, i.e. the data symbols (W1,SX), ..., (WN,SX), X having a value comprised between 1 and K, are corrected by the outer correcting means 10 using an outer syndrome evaluated for the data symbols with the coordinate SX and stored in the syndrome storage means 7. The correction involves as usual detecting errors in data symbols and replacing erroneous data symbols by a data symbol having a correct value.
It is possible to include erasure polynomial means (not shown) in the RS error correction device 1. The erasure polynomial means are used to indicate coordinates of erroneous data symbols in a RS code word. Having this information the inner correcting means 10 do not anymore need to determine these coordinates and the number of data symbols for which a correct value may be computed is increased. Thus a capacity of the RS error correction device 1 to correct erroneous data symbols is increased.
The input means 2 may comprise a buffer (not shown) which may e.g. be realized by a First In First Out (FIFO) type buffer. The FIFO buffer should at least be a large enough to stored a RS code word from the RS block.

The storage device 9 may also be connected to an external device (not shown), i.e. a device distinct from the RS error correction device 1. The storage device 9 may in fact be an integral part of the external device.

The external device may use the storage device 9 for its own purposes, e.g. as a cache memory to cache data. In this case the storage device 9 is shared by the external device and by the RS error correction device 1. The external device may advantageously make use of the inner and outer corrected RS code words stored in the storage device 9. The external device may e.g. extract the data contained in the data symbols of the inner and outer corrected RS code words and copy it to cache memory. As another example the external device may be realized as an integrated circuit which includes the storage device 9 and which processes the inner an outer corrected RS code words to extract picture data for movies.

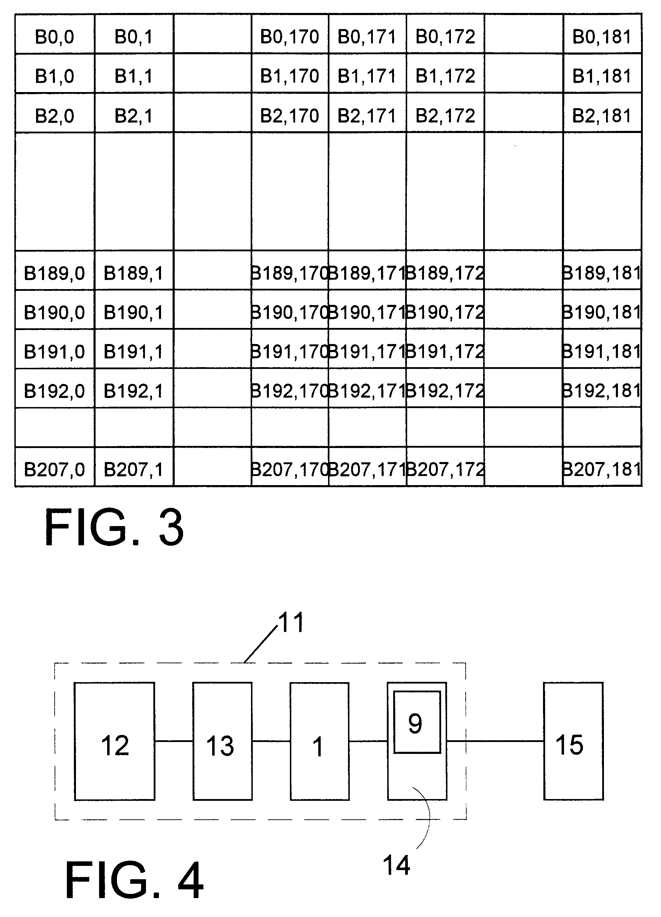

FIG. 3 shows a RS block as used e.g. to RS code data on a DVD. Such a RS block may also be called an Error Correction Code (ECC) block. The ECC block comprises 208 RS code words of 182 symbols $B_{i,j}$ (i is an index number of the RS code word comprised between 0 and 207, j is an index number for the coordinate of the symbol comprised between 0 and 181) each. 192 of these RS code words each contain 172 data symbols and 10 inner parity symbols; 16 RS code words of these RS code words contain each 172 outer parity symbols for the data symbols from the first 192 RS code words and 10 inner parity symbols for the RS code word itself. The data and parity symbols each comprise one byte (i.e. 8 bits) of information.

FIG. 4 contains a schematic representation of a data reading and/or writing device 11. A data medium 12 contains data stored and RS coded in RS block. The data medium may e.g. be a DVD or a magnetic tape. Reading means 13 deliver RS blocks from the data medium 12 to the RS error correcting device 1. The latter uses a storage device 9 comprised in an external device 14 which interfaces the data reading and/or writing device 11 to an outside device 15. The outside device 15 may e.g. be a computer bus in the IDE or IEEE-1394 standard. The IDE and IEEE-1394 standards are widespread in personal computers as used in industry. Accordingly the interface 14 may be an ATAPI, IEEE-1394 or SCSI interface. The storage device 9 in the interface 14 may be used as a cache memory and as such is shared with the RS error correction device 1.

## Claims

1. A Reed-Solomon (RS) error correction device (1) for correcting data providing from a RS block having a plurality of RS code words (W1, ..., WQ), each of said RS code words containing data and/or parity symbols ((W1,S1), ..., (WQ,SM)) such to enable an inner and an outer RS-coding of the data, comprising input means (2) to receive said RS code words from said RS block, first syndrome evaluating means (4) which evaluate inner syndromes for said RS code words, inner correcting means (5) for correcting said RS code words using said inner syndromes to obtain inner corrected RS code words, second syndrome evaluating means (6) which evaluate outer syndromes for at least said data symbols of at least one of said inner corrected RS code words and which comprise syndrome storage means (7) for storing said outer syndromes, characterized in that it further comprises output means (8) for outputting said inner corrected RS code words directly or indirectly to a storage device (9) which is not comprised in the RS error correction device, and outer correcting means (10) which enable an outer correction of said symbols in said inner corrected RS code words in said storage device using said outer syndromes stored in said syndrome storage means.

2. A RS error correction device according to claim 1, characterized in that it comprises erasure polynomial means which allows to determine a coordinate of erroneous data and/or parity symbols in said RS code words.

3. A RS error correction device according to anyone of claims 1 or 2, characterized in that said input means comprise a buffer to store said RS code words.

4. A RS error correction device according to anyone of claims 1 to 3, characterized in that said data and/or parity symbols are 8 bits long.

5. A RS error correction device according to anyone of claims 1 to 4, characterized in that said storage device is also connected to an external device which uses said storage device to at least store information.

6. A data reading and/or writing device (11) which reads and/or writes data from and/or to a data medium (12), said data being organized on said data medium in at least one Reed-Solomon (RS) block having a plurality of RS code words, each of said RS code words containing data and/or parity symbols such to enable an inner and an outer RS coding of said data, comprising interface means (14) which have a storage device (9), reading means (13) to receive said RS code words from said RS block, first syndrome evaluating means which evaluate inner syndromes for said RS code words, inner correcting means for correcting said RS code words using said inner syndromes to obtain inner corrected RS code words, second syndrome evaluating means which evaluate outer syndromes for at least said data symbols of at least one of said inner corrected RS code words and which comprise syndrome storage means for storing said outer syndromes, characterized in that, said interface means are directly or indirectly connected to said inner correcting means such that said inner corrected RS code words may be stored in said storage device and indirectly connected through outer correcting means to said syndrome storage means, said outer correcting means enabling an outer correction of said symbols in said inner corrected RS code words in said storage device using said outer syndromes stored in said syndrome storage means.

7. A data reading and/or writing device according to claim 6, characterized in that said interface means comply with an ATAPI interface.

8. A data reading and/or writing device according to claim 6, characterized in that said interface means comply with an IEEE-1394 standard interface.

9. A data reading and / or writing device according to claim 6, characterized in that said interface means comply with a SCSI interface.

10. A data reading and/or writing device according to anyone of claims 6 to 9, characterized in that said interface means comprise processing means to process the data symbols contained in said corrected RS code words stored in said storage device.

11. A data reading and/or writing device according to anyone of claims 6 to 10, characterized in that said storage device is used as a cache memory.

12. A method for correcting data organized inside of a Reed-Solomon (RS) block in RS code words containing data and/or parity symbols such to enable an inner and an outer RS coding of said data, by using a Reed-Solomon error correction device comprising the steps of

- inputting a RS code word,
- determining an inner syndrome for said RS code word,
- correcting said RS code word using said inner syndrome and obtaining an inner corrected RS code word,
- determining outer syndromes for at least said data symbols of at least one inner corrected RS code word,
- storing said outer syndromes in a syndrome storage device,

characterized in that it further comprises the steps of

- outputting said inner corrected RS code word to a storage device which is external to said Reed-Solomon error correction device,
- performing an outer correction of said data symbols of said inner corrected RS code words in said storage device using said stored outer syndromes.

|  | S1 | S2 |  | SK | SL |  | SM |
|---|---|---|---|---|---|---|---|
| W1 |  |  |  |  |  |  |  |
| W2 |  |  |  |  |  |  |  |
|  |  |  |  |  |  |  |  |
| WN |  |  |  |  |  |  |  |
| WP |  |  |  |  |  |  |  |
|  |  |  |  |  |  |  |  |
| WQ |  |  |  |  |  |  |  |

# FIG. 1

# FIG. 2

| B0,0 | B0,1 | | B0,170 | B0,171 | B0,172 | | B0,181 |
|---|---|---|---|---|---|---|---|
| B1,0 | B1,1 | | B1,170 | B1,171 | B1,172 | | B1,181 |
| B2,0 | B2,1 | | B2,170 | B2,171 | B2,172 | | B2,181 |
| | | | | | | | |
| | | | | | | | |
| B189,0 | B189,1 | | B189,170 | B189,171 | B189,172 | | B189,181 |
| B190,0 | B190,1 | | B190,170 | B190,171 | B190,172 | | B190,181 |
| B191,0 | B191,1 | | B191,170 | B191,171 | B191,172 | | B191,181 |
| B192,0 | B192,1 | | B192,170 | B192,171 | B192,172 | | B192,181 |
| | | | | | | | |
| B207,0 | B207,1 | | B207,170 | B207,171 | B207,172 | | B207,181 |

# FIG. 3

# FIG. 4

European Patent
Office

**EUROPEAN SEARCH REPORT**

Application Number

EP 97 40 2487

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | K.A. SCHOUHAMER IMMINK: "The Digital Versatile Disc (DVD): System Requirements and Channel Coding" SMPTE JOURNAL, 1 August 1996, pages 483-489, XP000627183 * page 485, column 2, line 20 - page 486, column 2, line 12 * | 1-12 | H03M13/00 G11B20/18 |
| Y | H. YAMAUCHI, H. MIYAMOTO, T. SAKAMOTO, T. WATANABE, H. TSUDA AND R. YAMAMURA: "A 24X-SPEED CIRC DECODER FOR A CD-DSP/CD-ROM DECODER LSI" IEEE TRANSACTIONS ON CONSUMER ELECTRONICS, vol. 43, no. 3, August 1997, pages 483-490, XP002055400 * figure 9 * | 1-12 | |
| A | EP 0 653 847 A (AT&T CORP.) * column 2, line 38 - column 6, line 32; figure 1 * | 1-12 | |
| A | R. NASS: "WHICH INTERFACE CONNECTS THE DISK DRIVE TO A SYSTEM" ELECTRONIC DESIGN, vol. 43, no. 15, 24 July 1995, CLEVELAND, OH, US, page 57,58,60,62,67,68 XP000531745 * page 57, column 1, line 1 - page 60, column 2, line 26 * | 7,9 | TECHNICAL FIELDS SEARCHED (Int.Cl.6) H03M G11B |
| A | R.H.J. BLOKS: "THE IEEE-1394 HIGH SPEED SERIAL BUS" PHILIPS JOURNAL OF RESEARCH, vol. 50, no. 1/2, 1996, pages 209-216, XP002055401 * page 209, line 1 - page 216, last line * | 8 | |

-/--

The present search report has been drawn up for all claims

| Place of search | Date of completion of the search | Examiner |
|---|---|---|
| THE HAGUE | 12 February 1998 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## EUROPEAN SEARCH REPORT

European Patent
Office

**Application Number**

EP 97 40 2487

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | S.B. WICKER AND V. BHARGAVA, EDS.: "ALGORITHMS AND ARCHITECTURES FOR THE DESIGN OF A VLSI REED-SOLOMON CODEC" 1994 , IEEE PRESS , PISCATAWAY, NJ XP002055402 * page 60, line 1 - page 107, last line * --- | 2 | |
| A | US 4 680 764 A (SONY CORP.) * column 12, line 37 - column 12, line 45 * ----- | 2 | |
| | | | TECHNICAL FIELDS SEARCHED (Int.Cl.6) |

The present search report has been drawn up for all claims

| Place of search | Date of completion of the search | Examiner |
|---|---|---|
| THE HAGUE | 12 February 1998 | Van Staveren, M |

EPO FORM 1503 03.82 (P04C01)